# EUROPÄISCHE PATENTANMELDUNG

(11) **EP 2 644 740 A2**
(43) Veröffentlichungstag der Anmeldung: **02.10.2013**
(21) Anmeldenummer: 13158683.6
(22) Anmeldetag: 12.03.2013
(51) Int. Cl.: C23C 14/50, C23C 14/54, H01L 21/302, H01L 21/316, H01L 41/257, H01L 41/314

(54) **Verfahren zum Herstellen einer Dünnschicht auf einem Substrat**

(30) Priorität: 27.03.2012 DE 102012204853
(71) Anmelder: Siemens Aktiengesellschaft, 80333 München (DE)
(72) Erfinder: Pitzer, Dana, 85716 Unterschleissheim (DE); Schreiter, Matthias, 81379 München (DE); Schuh, Carsten, 85598 Baldham (DE); Steinkopff, Thorsten, 85658 Egmating (DE)

(57) **Zusammenfassung**

Die Erfindung betrifft ein Verfahren zum Herstellen einer Dünnschicht (6) auf einem Substrat (2) mit den Schritten: Koppeln des Substrats (2) mit einer Vorspanneinrichtung (1, 3) derart, dass das Substrat (2) mit der Vorspanneinrichtung (1, 3) isotrop in der Fläche gedehnt wird, wobei das Substrat (2) mit einer vorherbestimmten Vorspannung elastisch unter Zug gehalten wird; Abscheiden eines Dünnschichtmaterials auf das Substrat (2) mit einem Abscheideverfahren, bei dem unter Einwirkung von Wärme auf das Dünnschichtmaterial dieses auf dem Substrat (2) abgeschieden wird, so dass auf dem Substrat (2) eine Dünnschicht (6) mit dem Dünnschichtmaterial ausgebildet wird; Entkoppeln des Substrats (2) von der Vorspanneinrichtung (1, 3); Abkühlen der Dünnschicht (6) begleitet von einer Schrumpfung, wobei die vorherbestimmte Vorspannung mindestens so hoch ist, dass bei der Schrumpfung das Auftreten einer Zugspannung in der Dünnschicht (6) stets unterbunden ist.

## Beschreibung

Die Erfindung betrifft ein Verfahren zum Herstellen einer Dünnschicht auf einem Substrat.

Dünnschichten aus Bleizirkonattitanat (PZT) sind aufgrund ihrer vorteilhaften physikalischen Eigenschaften, wie beispielsweise einer hohen elektromechanischen Kopplung, einer hohen Dielektrizitätszahl oder einem hohen pyroelektrischen Koeffizienten, in der Mikrosystemtechnik weit verbreitet. Das Mikrosystem weist herkömmlich ein Substrat als einen Träger für die Dünnschicht auf, wobei das Substrat in der Regel aus Silizium hergestellt ist. In der Dünnschicht liegt das Bleizirkontattitanat als ein Mischkristall vor, der je nach zirkongehalt eine entsprechend unterschiedliche Kristallsymmetrie hat. Zirkonarmes Bleizirkonattitanat liegt vorrangig in der tetragonalen Phase vor, wohingegen zirkonreiches Bleizirkonattitanat vorrangig in der rhomboedrischen Phase vorliegt. Hat das Bleizirkonattitanat eine morphotrope Zusammensetzung, beispielsweise mit einem Zirkongehalt bei etwa 50 %, liegen gleichzeitig tetragonale und rhomboedrische Gefügebestandteile insbesondere als Körner in der Dünnschicht vor. Es ist bekannt, die Bleizirkonattitanat-Dünnschicht mit einem Abscheideverfahren, insbesondere einem Sputter-Prozess, auf das Substrat aufzubringen, wobei die Dünnschicht typischerweise (111)-textudriert vorliegt. Das heißt, die (111)-Richtungen aller Körner der Dünnschicht liegen nahezu parallel zur Flächennormalen der Substratoberfläche vor. Jedoch kann durch den Einsatz von Seed-Layern die Textur der Dünnschicht gezielt beeinflusst werden.

Für die makroskopische piezo- bzw. pyroelektrische Funktionalität der Bleizirkonattitanat-Dünnschicht ist eine Vorzugsrichtung der Polarisierung notwendig, wobei die optimale Ausrichtung der Vorzugsrichtung der Polarisierung vom jeweiligen gewünschten physikalischen Effekt, der mit der Dünnschicht erzielt werden soll, wie beispielsweise dem pyroelektrischen Effekt, abhängt. Zur Optimierung des pyroelektrischen Effekts ist die Vorzugsrichtung der Polarisierung der Dünnschicht möglichst parallel zur Oberflächennormalen der Substratoberfläche ausgerichtet. Da in der rhomboedrischen Phase die spontane Polarisation einer Gitterzelle in (111)-Richtung liegt, bietet an sich eine (111)-textudrierte Dünnschicht die Vorrausetzungen für eine bezüglich des pyroelektrischen Effekts optimale Ausrichtung der Polarisation.

Der pyroelektrische Effekt der Dünnschicht wird durch einen pyroelektrischen Koeffizienten der Dünnschicht definiert. Die Größe des pyroelektrischen Koeffizienten der Dünnschicht ist im Wesentlichen von der Zusammensetzung der Bleizirkonattitanat-Dünnschicht abhängig. Ist die Dünnschicht zirkonarm, liegt die Dünnschicht nach ihrer Deposition und Abkühlung auf Raumtemperatur in einer selbstpolarisierten Form vor. Das heißt, die beim Abscheiden des Bleizirkonattitanats gewachsene (111)-orientierte Dünnschicht ändert ihren Polarisationszustand nicht mehr bei der sich anschließenden Abkühlung. Im Gegensatz dazu verliert die Dünnschicht, die reich an Zirkon ist, die Selbstpolarisation während der Abkühlung. Dieser Verlust der Selbstpolarisation erweist sich insofern als nachteilig, als für (111)-orienierte rhomboedrische Bleizirkonattitanat-Dünnschichten aufgrund der optimalen Ausrichtung der Polarisation ein deutlich höherer pyroelektrischer Effekt als bei tetragonaler Zusammensetzung der Dünnschicht zu erwarten ist.

Ist beispielsweise ein Infrarotlichtsensor auf Basis der Bleizirkonattitanat-Dünnschicht aufgebaut, geht die Größe des pyroelektrischen Koeffizienten der Dünnschicht linear in die Stärke des Sensorausgangssignals ein, so dass bei Erzielen des starken pyroelektrischen Effekts eine hohe Empfindlichkeit des Sensors erreichbar ist. Somit kommen für den Infrarotlichtsensor mit der hohen Sensorempfindlichkeit lediglich Bleizirkonattitanat-Dünnschichten in Frage, die einen geringen Anteil an Zirkon aufweisen.

Aufgabe der Erfindung ist es, ein Verfahren zum Herstellen einer Dünnschicht auf einem Substrat zu schaffen, deren Funktionalität hoch ist.

Die Aufgabe wird gelöst mit den Merkmalen des Patentanspruchs 1. Bevorzugte Ausgestaltungen dazu sind in den weiteren Patentansprüchen angegeben.

Das erfindungsgemäße Verfahren zum Herstellen einer Dünnschicht auf einem Substrat weist die Schritte auf: Koppeln des Substrats mit einer Vorspanneinrichtung derart, dass das Substrat mit der Vorspanneinrichtung isotrop in der Fläche gedehnt wird, wobei das Substrat mit einer vorherbestimmten Vorspannung elastisch unter Zug gehalten wird; Abscheiden eines Dünnschichtmaterials auf das Substrat mit einem Abscheideverfahren, bei dem unter Einwirkung von Wärme auf das Dünnschichtmaterial dieses auf dem Substrat abgeschieden wird, so dass auf dem Substrat eine Dünnschicht mit dem Dünnschichtmaterial ausgebildet wird; Entkoppeln des Substrats von der Vorspanneinrichtung; Abkühlen der Dünnschicht begleitet von einer Schrumpfung, wobei die vorherbestimmte Vorspannung mindestens so hoch ist, dass bei der Schrumpfung das Auftreten einer Zugspannung in der Dünnschicht stets unterbunden ist.

Bevorzugtermaßen ist die Vorspannung mindestens so hoch, dass nach dem Abkühlen der Dünnschicht in dieser lediglich Druckspannungen auftreten. Außerdem ist es bevorzugt, dass das Substrat aus Silizium ist. Bevorzugt ist es ferner, dass das Dünnschichtmaterial Bleizirkonattitanat ist. Hierbei ist es bevorzugt, dass das Bleizirkonattitanat überwiegend in der rhomboedrischen Phase vorliegt, d.h. dass das Bleizirkonattitanat sowohl in der rhomboedrischen Phase als auch in der tetragonalen Phase vorliegt, wobei die rhomboedrische Phase überwiegt. Bevorzugtermaßen ist die Dünnschicht nach dem Abkühlen selbstpolarisiert.

Erfindungsgemäß weist die Vorspanneinrichtung einen Klemmring auf, der vor dem Abscheiden des Dünnschichtmaterials auf das Substrat aufgelegt wird und zusammen mit dem Substrat isotrop elastisch verformt wird, wobei das Dünnschichtmaterial derart auf dem Substrat an dessen konvexen Seite abgeschieden wird, dass das Dünnschichtmaterial im Inneren des Klemmrings angesiedelt wird und an dem Innenrand des Klemmrings zugfest anhaftet. Zum isotrop und elastischen Verformen des Substrats zusammen mit dem Klemmring wird das Substrat bevorzugt auf eine konvexe Oberfläche gedrückt. Hierbei hat die Oberfläche bevorzugt eine Kugelkalottenform. Außerdem ist es bevorzugt, dass das Abscheideverfahren ein Sputterverfahren ist.

Silizium hat einen Wärmeausdehnungskoeffizienten von 2,6 ppm/K, wohingegen Bleizirkonattitanat einen Wärmeausdehnungskoeffizienten von 6 bis 7 ppm/K hat. Wird wie herkömmlich das Bleizirkonattitanat-Material auf das Silizium-Substrat aufgetragen, wobei insbesondere bei der Verwendung des Sputter-Verfahrens die von dem Bleizirkonattitanat aufgebaute Dünnschicht und das das Silizium aufweisende Substrat eine hohe Temperatur während des Auftragens haben. Dadurch, dass der Wärmeausdehnungskoeffizient von Silizium kleiner ist als von Bleizirkonattitanat, würde bei einem herkömmlichen Verfahren zum Herstellen der Dünnschicht auf dem Substrat, bei dem die Vorspanneinrichtung nicht vorgesehen ist, während des Abkühlens sich ein zugspannungszustand in der Dünnschicht einstellen. Dadurch kommt es zu einer Entpolung von dem rhomboedrischen Bleizirkonattitanat, wodurch der pyroelektrische Effekt der Dünnschicht vermindert wird.

Erfindungsgemäß wird dies durch das Vorsehen der Vorspanneinrichtung unterbunden, wobei mit der Vorspanneinrichtung das Substrat isotrop derart gedehnt wird, dass beim Abkühlen der Dünnschicht das Auftreten einer Zugspannung in der Dünnschicht stets unterbunden ist. Somit wird erfindungsgemäß das Substrat vor dem Abscheiden des Dünnschichtmaterials mit der Vorspanneinrichtung derart gezielt vorgespannt, dass während der Abkühlphase die in der Dünnschicht potentiell sich ausbildende Zugspannungskomponente kompensiert wird. Bevorzugt ist es, dass die Zugspannungskomponente überkompensiert wird, wobei auch nach der Abkühlung der Dünnschicht innerhalb derselben lediglich Druckspannungen auftreten.

Beim Auftreten von Zugspannungen in der Dünnschicht verliert sich die Selbstpolarisation von rhomboedrischem Bleizirkonattitanat bei der Abkühlung der Dünnschicht nach der Abscheidung. Die Ursache für diesen Polarisationsverlust liegt in dem Auftreten von den mechanischen Zugspannungen in der Dünnschicht. Ist das Substrat aus dem Silizium und die Dünnschicht aus dem Bleizirkonattitanat gebildet, so ist das Verhältnis der Wärmeausdehnungskoeffizienten dieser Materialien derart unterschiedlich, dass sich beim Abkühlen der Dünnschicht und des Substrats ein biaxialer Spannungszustand in der Dünnschicht einstellt, durch den der Polarisationszustand von Domänen der Dünnschicht beeinträchtigt ist.

Tetragonales (111)-textudriertes Bleizirkonattitanat und rhomboedrisches (111)-textudriertes Bleizirkonattitanat haben ein unterschiedliches Verhalten bezüglich der Umorientierung der Polarisation von Domänen. In der rhomboedrischen Phase ist die (111)-Kristallrichtung die Richtung der spontanen Polarisation, wodurch die Ausrichtung von Domänen unter zwei unterschiedlichen Winkeln zur Oberflächennormalen des Substrats erlaubt ist. Unter dem Einfluss der mechanischen Zugspannungen kommt es zu einem Spannungsabbau infolge eines Umklappens von Domänen aus der einen Ausrichtung in die andere Ausrichtung. In der tetragonalen Phase hingegen bildet eine (001)-Kristallrichtung die Richtung der spontanen Polarisation. Für die Dünnschicht, die die (111)-orientierte Kristallrichtung hat, existiert damit nur ein einziger möglicher Winkel der Domänenausrichtung zur Oberflächennormalen des Substrats. Ein Umschalten der Domänen hat somit keinen Einfluss auf den Lateralspannungszustand der Dünnschicht und umgekehrt. Dadurch bleibt der Polungszustand des tetragonalen (111)-textudrierten Bleizirkonattitanats auch unter dem Einfluss von Zugspannungen erhalten.

Erfindungsgemäß wird die Entpolung der selbstpolarisierten Bleizirkonattitanat-Dünnschicht für die rhomboedrische Zusammensetzung vermieden und die Selbstpolung erhalten. Dies wird dadurch erreicht, dass die Dünnschicht während und insbesondere nach der Abkühlung unter Druckspannung gehalten wird, wodurch auch in der rhomboedrischen Phase die Selbstpolung der Dünnschicht erhalten bleibt. Im Fall von pyroelektrischen Anwendungen der Dünnschicht ist aufgrund der optimalen Ausrichtung der Polarisation eine Verbesserung des pyroelektrischen Effekts erzielt. Etwaige notwendige Zwischenschichten, die an der Dünnschicht vorgesehen werden, wie zum Beispiel Elektroden, haben keinen Einfluss auf den erfindungsgemäß erzielten Effekt.

Bevorzugt ist die Vorspanneinrichtung von einem Klemmring gebildet, der auf dem Substrat aufliegt, wobei der Klemmring zusammen mit dem Substrat auf die kugelkalottenförmige Oberfläche gedrückt wird. Nachdem das Dünnschichtmaterial auf dem Substrat und in dem Klemmring abgeschieden ist, wird der Klemmring zusammen mit dem Substrat von der kugelkalottenförmige Oberfläche genommen, wobei das Substrat und der Klemmring zusammen mit der in dem Klemmring ausgebildeten Dünnschicht eine ebene Form annehmen. Dadurch wird der Krümmungsradius der Dünnschicht und des Substrats nach dem Abscheiden des Dünnschichtmaterials derart stark verändert, dass die Dünnschicht unter Druckspannung gesetzt wird, wodurch sich beim Abkühlen eventuell sich einstellende Zugspannungskomponenten kompensiert werden. Dadurch wird die Depolarisieren der Dünnschicht unterbunden.

Im Folgenden wird die Erfindung anhand einer bevorzugten Ausführungsform mit Bezugnahme auf die schematischen Zeichnungen erläutert. Es zeigen:

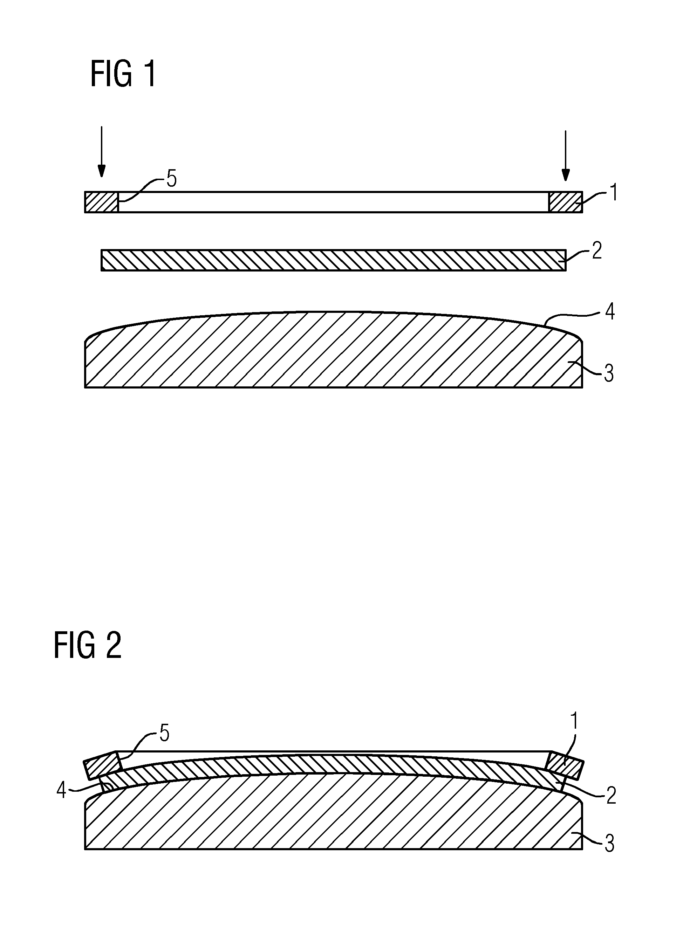

Figuren 1 bis 4 Querschnittsdarstellungen bezüglich aufeinanderfolgende Verfahrensschritte zum Herstellen einer Dünnschicht auf einem Substrat unter Verwenden einer Vorspanneinrichtung.

Wie es aus den Figuren 1 bis 4 ersichtlich ist, weist eine Vorspanneinrichtung einen Klemmring 1 auf. Der Klemmring 1 ist aus einem elastischen Material hergestellt, wobei der Klemmring 1 aus der Ebene, zu der die Achse des Klemmrings 1 normal ist, konvex verformt heraustreten kann. Ferner weist die Vorspanneinrichtung einen Substratteller 3 auf, der eine Oberfläche 4 hat, die derart konvex geformt ist, dass die Oberfläche 4 die Form einer Kugelkalotte hat.

Ein Verfahren zum Herstellen einer Dünnschicht 6 auf einem Substrat 2 ist in seiner Abfolge in den Figuren 1 bis 4 dargestellt. Gemäß Figur 1 ist das Substrat 2 bereitgestellt, wobei der Klemmring 1 auf das Substrat 2 gelegt wird (siehe Pfeile 1 in Figur 1). Der Klemmring 1 ist eben ausgebildet, so dass durch den Klemmring 1 sich die Ebene erstreckt, zu der die Achse des Klemmrings 1 normal ist. Der Klemmring 1 weist einen Innenrand 5 auf, wobei das Substrat 2 eine derart große Längserstreckung hat und der Klemmring 1 derart auf das Substrat 2 gelegt wird, dass der Innenrand 5 des Klemmrings 1 vollständig auf dem Substrat 2 angeordnet ist und nicht etwa über den Rand des Substrats 1 vorsteht.

Wie es in Figur 2 gezeigt ist, wird in einem nächsten Verfahrensschritt der Klemmring 1 zusammen mit dem Substrat 2 auf die Oberfläche 4 des Substrattellers 3 gelegt, wobei zwischen dem Klemmring 1 und der Oberfläche 4 das Substrat 2 angeordnet ist. Der Klemmring 1 wird derart stark auf den Substratteller 3 gedrückt, so dass das Substrat 2 sich an die Oberfläche 4 des Substrattellers 3 anschmiegt und somit die konvexe Form der Oberfläche 4 des Substrattellers 3 annimmt. Dadurch neigen sich die Querschnitte des Klemmrings 1 in analoger Weise, so dass die Stirnseiten des Klemmrings 1 parallel zur Oberfläche 4 des Substrattellers 3 angeordnet sind. Somit nimmt der Klemmring 1 eine der Oberfläche 4 des Substrattellers 2 nachempfundene, konvexe Gestalt ein. Dadurch wird erreicht, dass die Krümmung des Substrats 2 derart verändert wird, dass das Substrat 2 mit einer vorherbestimmten Vorspannung elastisch unter Zug gehalten wird.

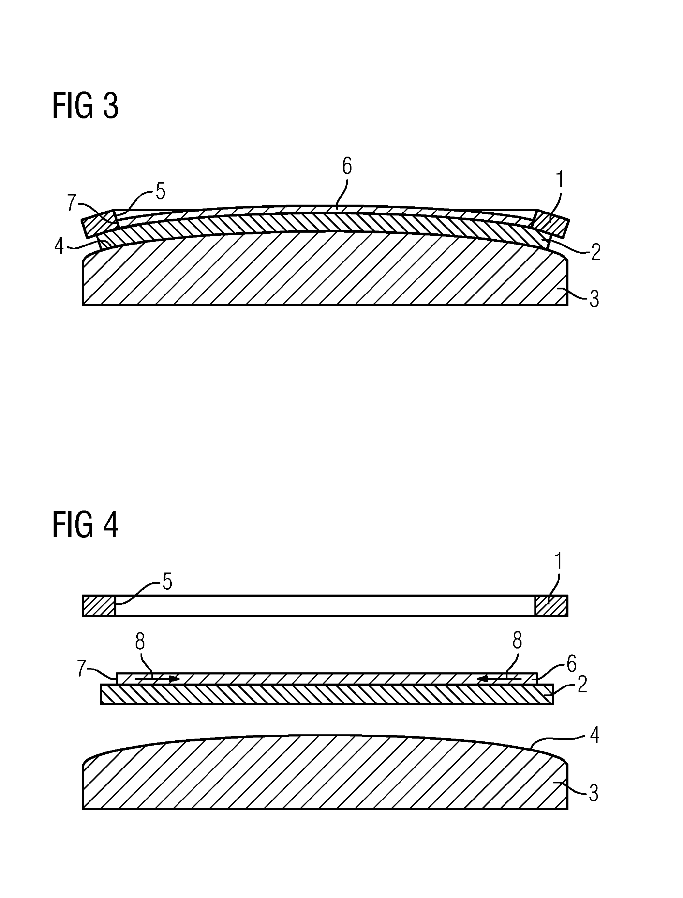

Wie es gemäß Figur 3 dargestellt ist, wird in einem nächsten Verfahrensschritt Dünnschichtmaterial auf das Substrat 2 im Inneren des Klemmrings 1 abgeschieden, wobei das Substratmaterial das Substrat 2 im Wesentlichen gleich dick bedeckt, so dass auf dem Substrat 2 eine Dünnschicht 6 ausgebildet wird. Die Dünnschicht 6 erstreckt sich vollständig bis zum Innenrand 5 des Klemmrings 1, wobei die Dünnschicht 6 mit ihrem Dünnschichtrand 7 zugfest an dem Innenrand 5 des Klemmrings 1 anhaftet. Das Dünnschichtmaterial wird beispielsweise mit einem Sputterverfahren auf das Substrat 2 abgeschieden, wobei das Substrat 2 und die Dünnschicht 6 beim Abscheiden des Dünnschichtmaterials eine wesentlich höhere Temperatur als die Raumtemperatur haben. Beim Abscheiden des Dünnschichtmaterials auf das Substrat 2 hat der Substratteller 3 bevorzugtermaßen die selbe Temperatur wie das Substrat 2.

Gemäß einem weiteren Verfahrensschritt wird, wie es in Figur 4 gezeigt ist, der Klemmring 1 zusammen mit dem Substrat 2 von dem Substratteller 3 entfernt (siehe Pfeile in Figur 4). Ferner wird der Klemmring 1 von dem Substrat 2 und der Dünnschicht 6 entfernt, so dass das Substrat 2 mit der darauf abgeschiedenen Dünnschicht 6 räumlich isoliert von dem Klemmring 1 und dem Substratteller 3 angeordnet sind. Dadurch nimmt das Substrat 2 wieder eine ebene Gestalt an, wodurch sich die Krümmung des Substrats 2 von der Krümmung der Oberfläche 4 des Substrattellers 3 zurück auf Null reduziert. Dadurch, dass die Dünnschicht 6 auf der konvexen Seite des Substrats 2 aufgebracht ist, bilden sich in der Dünnschicht 6 Druckspannungen aus. Die Druckspannungen ergeben sich aus der Größe der Krümmung der Oberfläche 4 des Substrattellers 3, wobei der Krümmungsradius der Oberfläche 4 des Substrattellers 3 derart vorherbestimmt ist, dass beim Abkühlen der Dünnschicht 6 in dieser lediglich die Druckspannungen 8 und keine Zugspannungen auftreten.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Herstellen einer Dünnschicht (6) auf einem Substrat (2) mit den Schritten:
- Koppeln des Substrats (2) mit einer Vorspanneinrichtung (1, 3) derart, dass das Substrat (2) mit der Vorspanneinrichtung (1, 3) isotrop in der Fläche gedehnt wird, wobei das Substrat (2) mit einer vorherbestimmten Vorspannung elastisch unter Zug gehalten wird, wobei die Vorspanneinrichtung einen Klemmring (1) aufweist, der vor dem Abscheiden des Dünnschichtmaterials auf das Substrat (2) aufgelegt wird und zusammen mit dem Substrat (2) isotrop elastisch verformt wird;
- Abscheiden eines Dünnschichtmaterials auf das Substrat (2) mit einem Abscheideverfahren, bei dem unter Einwirkung von Wärme auf das Dünnschichtmaterial dieses auf dem Substrat (2) abgeschieden wird, so dass auf dem Substrat (2) eine Dünnschicht (6) mit dem Dünnschichtmaterial ausgebildet wird, wobei das Dünnschichtmaterial derart auf dem Substrat (2) an der konvexen Seite abgeschieden wird, dass das Dünnschichtmaterial im Inneren des Klemmrings (1) angesiedelt wird und an dem Innenrand (5) des Klemmrings (1) zugfest anhaftet;
- Entkoppeln des Substrats (2) von der Vorspanneinrichtung (1, 3);
- Abkühlen der Dünnschicht (6) begleitet von einer Schrumpfung, wobei die vorherbestimmte Vorspannung mindestens so hoch ist, dass bei der Schrumpfung das Auftreten einer Zugspannung in der Dünnschicht (6) stets unterbunden ist.

2. Verfahren gemäß Anspruch 1, wobei die Vorspannung mindestens so hoch ist, dass nach dem Abkühlen der Dünnschicht (2) in dieser lediglich Druckspannungen auftreten.

3. Verfahren gemäß Anspruch 1 oder 2, wobei das Substrat (2) aus Silizium ist.

4. Verfahren gemäß einem der Ansprüche 1 bis 3, wobei das Dünnschichtmaterial Bleizirkonattitanat ist.

5. Verfahren gemäß Anspruch 4, wobei das Bleizirkonattitanat überwiegend in der rhomboedrischen Phase vorliegt.

6. Verfahren gemäß Anspruch 4 oder 5, wobei die Dünnschicht (6) nach dem Abkühlen selbstpolarisiert ist.

7. Verfahren gemäß einem der Ansprüche 1 bis 6, wobei zum isotropen konvexen und elastischen Verformen des Substrats (2) zusammen mit dem Klemmring (1) das Substrat (2) auf eine konvexe Oberfläche gedrückt (4) wird.

8. Verfahren gemäß Anspruch 7, wobei die Oberfläche (4) eine Kugelkalottenform hat.

9. Verfahren gemäß einem der Ansprüche 1 bis 8, wobei das Abscheideverfahren ein Sputterverfahren ist.
